(19) Europäisches Patentamt
European Patent Office
Office européen des brevets

(11) **EP 0 529 339 B1**

(12) **EUROPÄISCHE PATENTSCHRIFT**

(45) Veröffentlichungstag und Bekanntmachung des Hinweises auf die Patenterteilung:
**14.10.1998 Patentblatt 1998/42**

(51) Int Cl.6: **G01R 15/24**, G01R 29/08

(21) Anmeldenummer: **92113047.2**

(22) Anmeldetag: **31.07.1992**

(54) **Faseroptischer Sensor**

Fibre optic sensor

Capteur à fibre optique

(84) Benannte Vertragsstaaten:
**CH DE FR GB IT LI SE**

(30) Priorität: **29.08.1991 DE 4128687**

(43) Veröffentlichungstag der Anmeldung:
**03.03.1993 Patentblatt 1993/09**

(73) Patentinhaber: **ASEA BROWN BOVERI AG**
**5400 Baden (CH)**

(72) Erfinder: **Bohnert, Klaus, Dr.**
**CH-5443 Niederrohrdorf (CH)**

(56) Entgegenhaltungen:
**EP-A- 0 277 699**        **EP-A- 0 433 824**

- **OPTICS LETTERS Bd. 17, Nr. 9, 1. Mai 1992, WASHINGTON US Seiten 694 - 696 , XP000265235 K. BOHNERT ET AL. 'INTERROGATION OF A REMOTE ELLIPTICAL-CORE DUAL-MODE FIBER STRAIN SENSOR BY USING A TANDEM INTERFEROMETER CONFIGURATION'**
- **JOURNAL OF LIGHTWAVE TECHNOLOGY Bd. 8, Nr. 11, November 1990, NEW YORK US Seiten 1688 - 1696 , XP000174439 K.A. MURPHY ET AL. 'ELLIPTICAL-CORE TWO-MODE OPTICAL FIBER SENSOR IMPLEMENTATION METHODS'**
- **APPLIED OPTICS Bd. 29, Nr. 30, 20. Oktober 1990, NEW YORK US Seiten 4473 - 4480 A.S. GERGES ET AL. 'COHERENCE TUNED FIBER OPTIC SENSING SYSTEM, WITH SELF-INITIALIZATION, BASED ON A MULTIMODE LASER DIODE'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf das Gebiet der optischen Messung elektrischer Grössen. Sie betrifft einen faseroptischen Sensor, umfassend

a) eine Lichtquelle;
b) ein piezoelektrisches Sensorelement;
c) eine erste Zwei-Moden-Faser mit einem Eingangsende und einem Ausgangsende, in der sich der $LP_{01}$-Grundmodus und der gerade $LP_{11}$-Modus ausbreiten können, und welche zumindest teilweise an dem Sensorelement so fixiert ist, dass eine Dimensionsänderung des Sensorelements in einem elektrischen Feld zu einer Längenänderung in der Faser führt;
d) Mittel zum Messen der feldbedingten Längenänderung der Faser;
e) eine erste sowie eine zweite Monomode-Faser zur Uebertragung des Lichts zwischen der Lichtquelle und dem Eingangsende der ersten Zwei-Moden-Faser sowie dem Ausgangsende der ersten Zwei-Moden-Faser und dem Eingang der Messmittel, wobei
f) die erste Monomode-Faser polarisationserhaltend ausgebildet ist oder Mittel zur aktiven Kontrolle der Polarisation vorhanden sind.

Ein derartiger faseroptischer Sensor ist z.B. aus dem Artikel von K. A. Murphy et al., "Elliptical-Core Two-Mode Optical-Fiber Sensor Implementation Methods", Journal of Lightwave Technology 8 (11), S. 1688 - 1696 (1990) bekannt.

**STAND DER TECHNIK**

In verschiedenen Druckschriften wie z.B. den Europäischen Patentanmeldungen EP-A1-0 316 619, EP-A1-0 316 635 und EP-A1-0 433 824 oder den Artikeln von K. Bohnert und J. Nehring in Appl.Opt. 27, S.4814-4818 (1988), bzw. Opt.Lett. 14, S.290-292 (1989), sind bereits faseroptische Sensoren zur Messung von elektrischen Feldern und Spannungen beschrieben worden.

Das dabei verwendete Messprinzip beruht auf dem inversen Piezoeffekt in Materialien mit ausgesuchter Kristallsymmetrie. Die zeitlich periodische Dimensionsänderung, die ein entsprechender piezoelektrische Körper in einem elektrischen Wechselfeld erfährt, wird auf eine an dem Körper fixierte Glasfaser übertragen. Die Längenänderung der Faser ist dann proportional zur Feld- bzw. Spannungsamplitude und wird interferometrisch gemessen und ausgewertet.

Für die interferometrische Messung können verschiedene Arten von Glasfaser-Interferometern eingesetzt werden. Aufgrund seiner Einfachheit ist von diesen Arten das aus dem Artikel von B. Y. Kim et al., Opt.Lett. 12, S.729-731 (1987), bekannte Zwei-Moden-Faser-Interferometer von besonderem Interesse. Die Parameter der Sensorfaser sind bei diesem Interferometer so gewählt, dass sich in der Faser genau zwei Moden (der $LP_{01}$-Grundmodus und der gerade $LP_{11}$-Modus) ausbreiten können.

Beim Zwei-Moden-Faser-Interferometer wird Licht aus einer kohärenten Lichtquelle, z.B. einer Laserdiode, durch eine Zwei-Moden-Faser geschickt, welche an einem piezoelektrischen Sensorelement für das elektrische Feld E fixiert ist. Durch das Licht werden die beiden Moden angeregt und breiten sich in der Faser unterschiedlich aus. Am Faserende kann man dann ein Interferenzmuster beobachten, welches sich aus der Ueberlagerung dieser beiden Moden ergibt. Eine Längenänderung der Faser führt dabei zu einer differentiellen Phasenverschiebung zwischen beiden Moden, die sich in einer entsprechenden Aenderung des Interferenzmusters äussert.

Die beiden nebeneinanderliegenden Substrukturen des Interferenzmusters werden mit zwei Detektoren (z.B. in Form von Photodioden) detektiert. An deren Ausgang liegen zwei um 180° phasenverschobene Signale $V_{11}$ und $V_{12}$ vor:

$$(1) \qquad V_{11} = (1/2)V_0(1 + a^* \cos \Phi(t))$$

$$(2) \qquad V_{12} = (1/2)V_0(1 - a^* \cos \Phi(t))$$

mit $\Phi(t) = A^* \sin \Omega t + \theta(t)$. Die Phasenverschiebung $\Phi(t)$ zwischen den beiden Moden setzt sich also zusammen aus einem durch das zu messende Wechselfeld hervorgerufenen zeitlich periodischen Anteil $A^* \sin \Omega t$ (A ist dabei proportional zur Amplitude des Feldes) und einem willkürlichen Phasenterm $\theta(t)$, der sich z.B. infolge von temperaturbedingten Fluktuationen der Faserlänge ebenfalls zeitlich ändern kann. $V_0$ schliesslich ist proportional zur optischen Leistung und a ist ein Mass für den Interferenzkontrast.

Der gesuchte Term $A^* \sin \Omega t$ wird häufig mit einem Homodyn-Detektionsverfahren aus den Ausgangssignalen der Detektoren gewonnen (für einen faseroptischen Sensor mit Ein-Moden-Faser siehe dazu: D. A. Jackson et al., Appl. Opt. 19, S.2926-2929 (1980); ein entsprechender faseroptischer Sensor mit Zwei-Moden-Faser ist in der eingangs zitierten Europäischen Anmeldung EP-A1-0 433 824 beschrieben). Bei diesem Verfahren wird die Sensorfaser zusätzlich über einen piezoelektrischen Modulator geführt. Mit Hilfe dieses Modulators 4 wird die Phasendifferenz $\Phi(t)$ auf + (pi/2) oder -(pi/2) (modulo 2pi) geregelt. Der Modulator ist dazu Bestandteil eines aus den Detektoren, einem Subtrahierer und einem Quadraturregler bestehenden Regelkreises, welcher die Differenzspannung

$$(3) \qquad V = V_{11} - V_{12} = V_0 {}^* a {}^* \cos\Phi(t)$$

entsprechend auf Null regelt.

Die beiden Anteile $A{}^*\sin\Omega t$ und $\theta(t)$ der Phasenverschiebung werden also durch den Modulator über eine entsprechende (entgegengesetzte) Längenänderung der Faser gerade ausgeglichen. Die am Modulator anliegende Spannung enthält dann einen langsam variierenden Anteil, der proportional zu $\theta(t)$ ist, und einen periodischen Anteil, der proportional zu $A{}^*\sin\Omega t$ ist. Der gesuchte Anteil $A{}^*\sin\Omega t$ wird über ein Hochpassfilter ausgefiltert und kann am Signalausgang abgenommen werden. Das Ausgangssignal ist dadurch unabhängig von etwaigen Fluktuationen der Laserintensität (d.h. $V_0$) und des Interferenzkontrastes a.

In einer Reihe von praktischen Anwendungen des Sensors (z.B. bei der Spannungsmessung in Freiluftanlagen) können verhältnismässig grosse Abstände zwischen dem eigentlichen Sensorkopf und der Sensorelektronik auftreten (10 m bis einige 100 m). Es ist unzweckmässig, diese Abstände mit der Zwei-Moden-Faser selbst zu überbrücken, da sich der Einfluss externer Störungen (Temperaturschwankungen, mechanische Erschütterungen etc.) mit zunehmender Faserlänge entsprechend vergrössert und das Signal/Rausch-Verhältnis verschlechtert. Die Lichtzuführung von der Laserdiode zum Interferometer und die Rückführung der Ausgangssignale des Interferometers sollten vielmehr über separate Glasfasern erfolgen, die nicht Bestandteil des Interferometers sind.

Bei dem oben beschriebenen Homodyn-Verfahren mit einem aktiven Phasen-Modulator wäre aber zusätzlich zu den Verbindungs-Glasfasern auch noch eine elektrische Verbindung zwischen der Sensorelektronik und dem Sensorkopf zur Ansteuerung des Modulators erforderlich. Die Attraktivität eines mit diesem Interferometertyp arbeitenden Sensors wäre dadurch sehr beschränkt.

Es ist deshalb in zwei älteren Deutschen Patentanmeldungen (Aktenzeichen P 41 14 253.5 und P 41 15 370.7) vorgeschlagen worden, anstelle der bekannten aktiven Signaldetektion, die einen zusätzlichen Modulator in der Messfaser mit entsprechender elektrischer Zuleitung erfordert, eine passive Signaldetektion vorzusehen, die auf dem Guoy-Effekt (siehe dazu: S. Y. Huang et al., Springer Proc. in Physics, Vol.44 "Optical Fiber Sensors", S. 3843, Springer Verlag Berlin, Heidelberg (1989)), d.h. dem Phasenunterschied zwischen den Moden und der daraus resultierenden Änderung des Interferenzmusters beim Übergang vom Nah- zum Fernfeld beruht: Die Substrukturen des Nah- und Fernfeldes (insgesamt 4) werden dabei im Sensorkopf mit optischen Mitteln separiert und können über separate Glasfasern zu einer entfernten Auswerteelektronik übertragen werden. Dort kann unter Verwendung von wenigstens drei dieser vier Substrukturen die gewünschte Information über die Längenänderung der Messfaser gewonnen werden.

Mit dieser vorgeschlagenen Lösung wird zwar eine vollständige elektrische Trennung zwischen Sensorkopf und Auswerteelektronik erreicht. Jedoch wird dieser Vorteil dadurch erkauft, dass zusätzliche optische Komponenten (Strahlteiler) und eine relativ aufwendige Elektronik eingesetzt werden müssen. Darüberhinaus muss eine Monomode-Laserdiode verwendet werden, die besondere Massnahmen zur Unterdrückung der Lichtrückstreuung aus dem Sensor in die Diode erforderlich macht.

Ein faseroptischer Dehnungssensor mit einer unempfindlichen Zu- und Wegleitungsfaser wird in der Veröffentlichung von K. A. Murphy et al., "Elliptical-Core Two-Mode Optical-Fiber Sensor Implementation Methods" diskutiert. Das Licht eines HeNe-Lasers mit grosser Kohärenzlänge durchläuft nacheinander eine polarisationserhaltende Monomodefaser mit elliptischem Kern, eine dehnungsempfindliche Zwei-Moden-Sensorfaser ebenfalls mit elliptischem Kern und eine Monomodefaser mit kreisrundem Kern. Letztere Faser fängt eine Substruktur des Interferenzmusters aus der Sensorfaser auf und führt die resultierende Intensitätsvariation einem Detektor zu. Diese Anordnung ermöglicht zwar eine störungsarme optische Signalübertragung zwischen Sensorfaser und Auswerteeinheit. Jedoch bleibt wegen der Interferenzbildung unmittelbar am Ende der Zwei-Moden-Sensorfaser das Problem bestehen, dass für eine aktive Signaldetektion ein zusätzlicher Modulator in der Messfaser erforderlich ist.

## DARSTELLUNG DER ERFINDUNG

Es ist daher Aufgabe der vorliegenden Erfindung einen faseroptischen Sensor zu schaffen, der einerseits eine störunempfindliche Trennung von Sensorkopf und Auswerteelektronik ermöglicht, sich andererseits aber auch durch einfachen Aufbau und hohe Messgenauigkeit auszeichnet.

Die Aufgabe wird bei einem Sensor der eingangs genannten Art dadurch gelöst, dass

(g) die Lichtquelle eine Mehr-Moden-Laserdiode ist;

(h) die Messmittel eine zweite, zur ersten gleichartige Zwei-Moden-Faser umfassen;

(i) die Parameter der beiden Zwei-Moden-Fasern so gewählt sind, dass der Interferenzkontrast für die Gangunterschiede beider Moden in den einzelnen Zwei-Moden-Fasern und für die Summe der Gangunterschiede jeweils ungefähr gleich Null ist; und

j) die zweite Monomode-Faser polarisationserhaltend ausgebildet ist oder Mittel zur aktiven Kontrolle der Polarisation vorhanden sind.

Der Kern der Erfindung beruht darauf, für die Messung das Prinzip der Weisslicht-Interferometrie anzuwenden: Das Licht einer Mehr-Moden-Laserdiode wird der ersten Zwei-Moden-Faser über die insensitive erste Monomode-Faser zugeführt. Die Ankopplung erfolgt so, dass die beiden ausbreitungsfähigen Moden ($LP_{01}$-Grundmodus und gerader $LP_{11}$-Modus), vorzugsweise mit gleicher Intensität, angeregt werden. In der ersten Zwei-Moden-Faser erfahren die beiden Moden einen optischen Gangunterschied Delta $L_1$, für den der Interferenzkontrast vernachlässigbar klein ist. Am Ende der Sensorfaser treten deshalb keine Interferenzeffekte auf. Die beiden Moden werden zu etwa gleichen Teilen in eine zweite insensitive Monomode-Faser eingekoppelt und zu einer Detektionseinheit übertragen. Dort wird das Licht erneut in eine zweite Zwei-Moden-Faser eingekoppelt, die hinsichtlich ihrer Faserparameter und Länge mit der ersten Zwei-Moden-Faser gleichartig, insbesondere identisch ist.

Die Einkopplung erfolgt wiederum so, dass beide Moden etwa gleich stark angeregt werden. Licht, dass sich in der ersten Zwei-Moden-Faser im Grundmodus $LP_{01}$ ausgebreitet hat, breitet sich zu etwa gleichen Teilen im $LP_{01}$-und im geraden $LP_{11}$-Modus der zweiten Zwei-Moden-Faser aus. Gleiches gilt für Licht, welches sich in der ersten Zwei-Moden-Faser im $LP_{11}$-Modus ausgebreitet hat.

Am Ausgangsende der zweiten Zwei-Moden-Faser gibt es zwischen den Lichtwellen des $LP_{01}$-Modus einerseits und den Wellen des $LP_{11}$-Modus andererseits Gangunterschiede von Null, Delta $L_1$ und 2*Delta $L_1$. Modenanteile mit dem Gangunterschied Null interferieren dann miteinander, während die übrigen Anteile einen konstanten Intensitätsuntergrund liefern.

An dieser Stelle sei darauf hingewiesen, dass ein solches als Tandem-Interferometer bezeichnetes System grundsätzlich für herkömmliche Interferometer (Michelson) bereits aus dem Stand der Technik bekannt ist (siehe z.B. A. S. Gerges et al., Appl. Optics Vol.29, No.30, S.4473-4480 (1990)).

Eine bevorzugte Ausführungsform der Erfindung zeichnet sich dadurch aus, dass

(a) die zweite Zwei-Moden-Faser zumindest teilweise an einem piezoelektrischen Modulator fixiert ist;

(b) am Ausgangsende der zweiten Zwei-Moden-Faser zwei Detektoren zur Messung der Intensitäten der beiden Moden angeordnet sind;

(c) die Ausgangssignale der beiden Detektoren über einen Subtrahierer auf den Eingang eines Quadraturreglers gelangen;

(d) der Ausgang des Quadraturreglers den Modulator steuert; und

(e) das Ausgangssignal des Quadraturreglers über einen Hochpass auf einen Signalausgang gegeben wird.

Eine derartige, an sich bekannte Homodyn-Detektion mit aktiver Arbeitspunkt-Kontrolle und Kompensation des AC-Messsignals hat den Vorteil einer hohen Messempfindlichkeit bei gleichzeitig grosser Stabilität.

Weitere Ausführungsformen ergeben sich aus den abhängigen Ansprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig. 1        das grundsätzliche Schema eines Tandem-Interferometers mit Zwei-Moden-Fasern nach der Erfindung;

Fig. 2        den Interferenzkontrast V für ein mit einer Mehr-Moden-Laserdiode beleuchtetes Michelson-Interferometer in Abhängigkeit vom Gangunterschied Delta L;

Fig. 3A       die Intensität I am Ausgang eines Tandem-Interferometers für das Interferenzpaket O-ter Ordnung in Abhängigkeit von der Differenz im Gangunterschied (Delta $L_1$ - Delta $L_2$);

Fig. 3B       die Fig. 3A entsprechende Darstellung für "Interferenzpakete" mit Ordnungen bis ± 2;

Fig. 4        die Intensität I für V=1 in Abhängigkeit von der Phase Φ; und

Fig. 5 den schematischen Aufbau einer bevorzugten Ausführungsform des erfindungsgemässen Sensors mit Homodyn-Detektion.

WEGE ZUR AUSFÜHRUNG DER ERFINDUNG

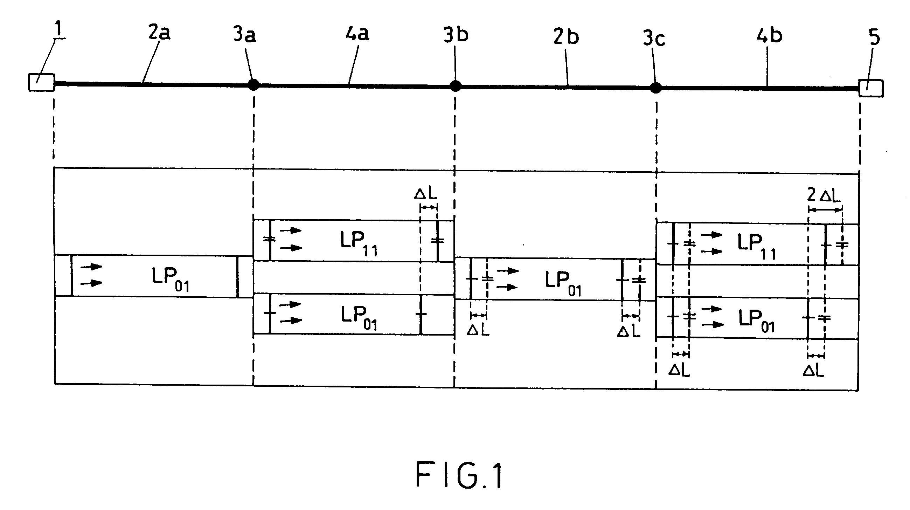

Der grundsätzliche (schematische) Aufbau eines Sensors nach der Erfindung und die Ausbreitung einer Wellenfront eines einzelnen, willkürlich herausgegriffenen Wellenzuges sind in Fig. 1 dargestellt. Das Licht aus einer Lichtquelle 1, einer Mehr-Moden-Laserdiode, breitet sich zunächst als Grundmodus $LP_{01}$ einer ersten (polarisationserhaltenden) Monomode-Faser 2a aus. Die betrachtete Wellenfront regt in einer durch einen ersten Spleiss 3a an die erste Monomode-Faser 2a angeschlossenen ersten Zwei-Moden-Faser 4a zwei neue Wellenfronten an, die sich im $LP_{01}$- und im geraden $LP_{11}$-Modus ausbreiten. Beide Fronten sind am Anfang der Faser noch in Phase, da sie von einer gemeinsamen Ausgangsfront erzeugt werden. Die Ankopplung an die erste Zwei-Moden-Faser im ersten Spleiss 3a erfolgt dabei vorzugsweise so, dass die Intensitäten der $LP_{01}$- und $LP_{11}$-Moden annähernd gleich sind.

Da die effektiven Brechungsindizes $n(LP_{01})$ und $n(LP_{11})$ für die beiden Moden verschieden sind, hat sich am Ende der ersten Zwei-Moden-Faser 4a zwischen den beiden Fronten ein optischer Gangunterschied

$$(4) \qquad \text{Delta } L = \text{Delta } L_1 = l(n(LP_{01})\text{-}n(LP_{11}))$$

akkumuliert (l bezeichnet hier die Länge der ersten Zwei-Moden-Faser 4a). Delta L ist derart, dass am Ende der ersten Zwei-Moden-Faser 4a keine Interferenzeffekte auftreten. Die beiden Wellenfronten regen in einer (ebenfalls polarisationserhaltenden) über einen zweiten Spleiss 3b angekoppelten zweiten Monomode-Faser 2b zwei neue Fronten an, die sich beide im $LP_{01}$-Modus ausbreiten. Der Gangunterschied Delta L bleibt deshalb in dieser Faser erhalten. Die Ankopplung erfolgt so, dass die $LP_{01}$- und $LP_{11}$-Moden etwa zu gleichen Anteilen in die zweite Monomode-Faser 2b eingekoppelt werden.

In einer zweiten, über einen dritten Spleiss angekoppelten Zwei-Moden-Faser 4b regen die beiden aus der zweiten Monomode-Faser 2b kommenden Wellenfronten jeweils zwei neue Fronten an, von denen sich jeweils eine im $LP_{01}$- und eine im $LP_{11}$-Mode ausbreitet. Die $LP_{01}$- und $LP_{11}$-Moden haben wiederum näherungsweise gleiche Intensitäten (um die Wellenfronten besser verfolgen zu können, sind in Fig. 1 solche, die aus dem $LP_{01}$-Modus der ersten Zwei-Moden-Faser 4a stammen, mit einem Querstrich, und solche, die aus dem $LP_{11}$-Modus stammen, mit zwei Querstrichen versehen).

Der Gangunterschied Delta L zwischen den $LP_{01}$- bzw. den $LP_{11}$-Frontenpaaren bleibt entlang der zweiten Zwei-Moden-Faser 4b erhalten. Zwischen dem $LP_{01}$-Frontenpaar einerseits und dem $LP_{11}$-Frontenpaar andererseits akkumuliert sich jedoch ein Phasenunterschied Delta $L_2$. Wenn die beiden Zwei-Moden-Fasern 4a und 4b hinsichtlich ihrer Faserparameter und Länge gleich sind, gilt: IDelta $L_2$I = IDelta $L_1$I = IDelta LI. Am Ausgangsende der zweiten Zwei-Moden-Faser gibt es zwischen den Lichtwellen des $LP_{01}$-Modus einerseits und den Wellen des $LP_{11}$-Modus andererseits Gangunterschiede von Null, Delta $L_1$ und 2*Delta $L_1$. Modenanteile mit dem Gangunterschied Null interferieren dann miteinander, während die übrigen Anteile einen konstanten Intensitätsuntergrund liefern. Die Interferenz wird schliesslich in einer nachfolgenden Detektionseinheit 5 ausgewertet.

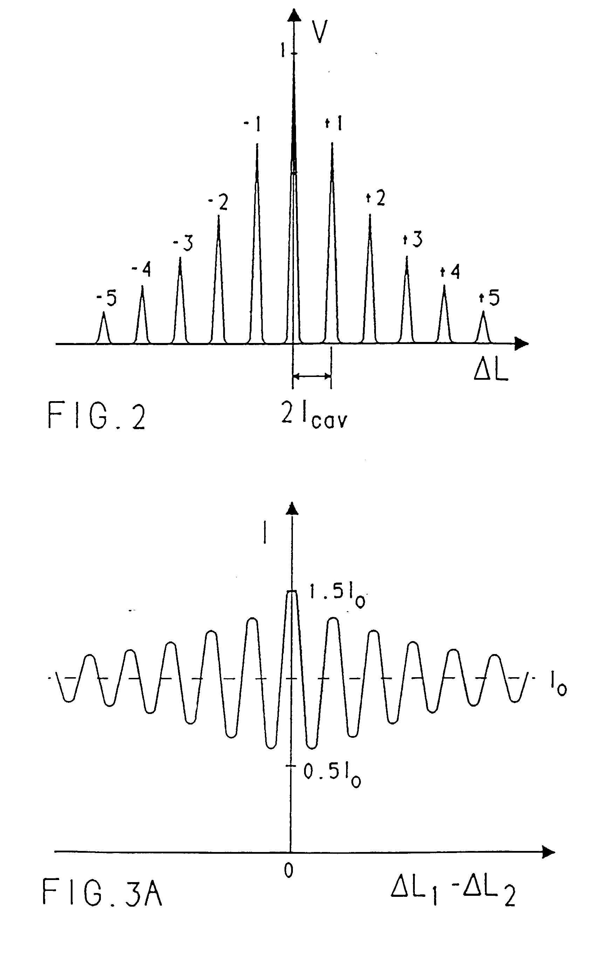

Zum weiteren Verständnis des Tandem-Zweimodenfaser-Interferometers nach der Erfindung wird zunächst ein einzelnes Michelson-Interferometer mit einer Mehr-Moden-Laserdiode als Lichtquelle betrachtet, wie es in dem bereits zitierten Artikel von A. S. Gerges et al. beschrieben ist. Trägt man den Interferenzkontrast V als Funktion des optischen Weglängenunterschieds Delta L zwischen den beiden Interferometerzweigen auf, so ergibt sich eine Serie von äquidistanten Spitzen wachsender Ordnung ±1, ±2, ±3, usw., die symmetrisch bezüglich der Spitze bei Delta L = 0 liegen (Fig. 2). Der Interferenzkontrast V ist dabei definiert als

$$(5) \qquad V = \frac{I_{max} - I_{min}}{I_{max} + I_{min}},$$

wobei $I_{max}$ und $I_{min}$ die Intensitäten der Maxima und Minima des Interferenzstreifenmusters sind. Die Lage der Spitzen ist gegeben durch

$$(6) \qquad \text{Delta } L = 2*p*l_{cav} \qquad p = 0, \pm1, \pm2,..$$

mit der Ordnungszahl p und der optischen Länge $l_{cav}$ des Laserresonators.

Zwischen den Spitzen ist V sehr klein, so dass hier nahezu keine Interferenz auftritt. Für gleiche Amplituden der interferierenden Wellen ist V(Delta L=O) = 1. Mit wachsender Ordnung IpI fällt die Höhe K der Spitzen monoton ab, gemäss der Beziehung K(Delta L) = exp(-Delta L/$L_{cm}$), wobei $L_{cm}$ die der spektralen Lasermodenbreite entsprechende Kohärenzlänge ist. K geht also für IDelta LI >> $L_{cm}$ gegen Null.

Beim Zweimodenfaser-Interferometer treten an die Stelle der Zweige des Michelson-Interferometers die $LP_{01}$- und $LP_{11}$-Moden. Mit zunehmender Faserlänge 1 wächst der Gangunterschied Delta L = l(n($LP_{01}$)-n($LP_{11}$)) zwischen den Moden linear mit 1 an. Der Interferenzkontrast V(l) als Funktion der Faserlänge durchläuft dann die gleiche Serie von Spitzen wie beim Michelson-Interferometer. Die Maxima liegen bei Faserlängen

$$(7) \qquad I_p = 2*p*I_{cav}/(n(LP_{01})-n(LP_{11})) \ .$$

Der Faserlängenunterschied zwischen benachbarten Spitzen ist folglich

$$(8) \qquad Delta\ l = 2*I_{cav}/Delta\ n_{eff}$$

mit Delta $n_{eff}$ = n($LP_{01}$)-n($LP_{11}$).

Damit am Ende der ersten Zwei-Moden-Faser 4a keine Interferenzeffekte auftreten, muss entweder der von der Faserlänge abhängige Gangunterschied Delta L sehr viel grösser sein als $L_{cm}$, oder 1 muss in einem Minimum zwischen zwei Spitzen der Funktion V(l) liegen (Interferenzeffekte am Ende der ersten Zwei-Moden-Faser 4a hätten unerwünschte Intensitätsschwankungen zur Folge).

Die Lichtintensität am Ausgang des Tandem-Zweimodenfaser-Interferometers ist gegeben durch (analog zu Gleichung (7) in dem Artikel von A. S. Gerges et al.):

$$(9) \qquad I = I_0\{1+V(Delta\ L_1)cos(\Phi_1)+V(Delta\ L_2)cos(\Phi_2)$$

$$+(1/2)V(Delta\ L_1+Delta\ L_2)cos(\Phi_1+\Phi_2)$$

$$+(1/2)V(Delta\ L_1-Delta\ L_2)cos(\Phi_1-\Phi_2)\}$$

$\Phi_1$ und $\Phi_2$ sind die den Gangunterschieden Delta $L_1$ und Delta $L_2$ entsprechenden Phasendifferenzen:

$$(10) \qquad \Phi_1 = \frac{2*pi*f_0}{c}Delta\ L_1$$

und

$$(11) \qquad \Phi_2 = \frac{2*pi*f_0}{c}Delta\ L_2 \ .$$

$f_0$ ist die mittlere Frequenz der Laserdiode, c ist die Lichtgeschwindigkeit. $I_o$ ist proportional zur optischen Leistung der Laserdiode. Delta $L_1$ und Delta $L_2$ sind gegeben durch

$$(12) \qquad Delta\ L_1 = l_1*Delta\ n^{(1)}_{eff}$$

$$(13) \qquad Delta\ L_2 = l_2*Delta\ n^{(2)}_{eff}.$$

$l_1$ und $l_2$ sind die Längen der beiden Zwei-Moden-Fasern 4a und 4b; Delta $n^{(1)}_{eff}$ und Delta $n^{(2)}_{eff}$ sind die effektiven Brechungsindex-Unterschiede der Moden.

Wie schon erwähnt ist Delta $n^{(1)}_{eff}$ = Delta $n^{(2)}_{eff}$ = Delta $n_{eff}$, $l_1$ = $l_2$ = l und folglich Delta $L_1$ = Delta $L_2$ = Delta L. Für einen gegebenen Fasertyp wird 1 dann so gewählt, dass

$$(14) \qquad V(Delta\ L_1) = V(Delta\ L_2) = V(Delta\ L) \approx 0$$

ist, und dass ausserdem

$$(15) \qquad V(Delta\ L_1 + Delta\ L_2) = V(2*Delta\ L) \approx 0$$

ist.

Gleichung (9) lautet dann

$$(16) \qquad I=I_0\{1+(1/2)V(Delta\ L_1\text{-}Delta\ L_2)cosz\}$$

mit $z = 2*pi*f_0*(1/c)(Delta\ L_1\text{-}Delta\ L_2)$.

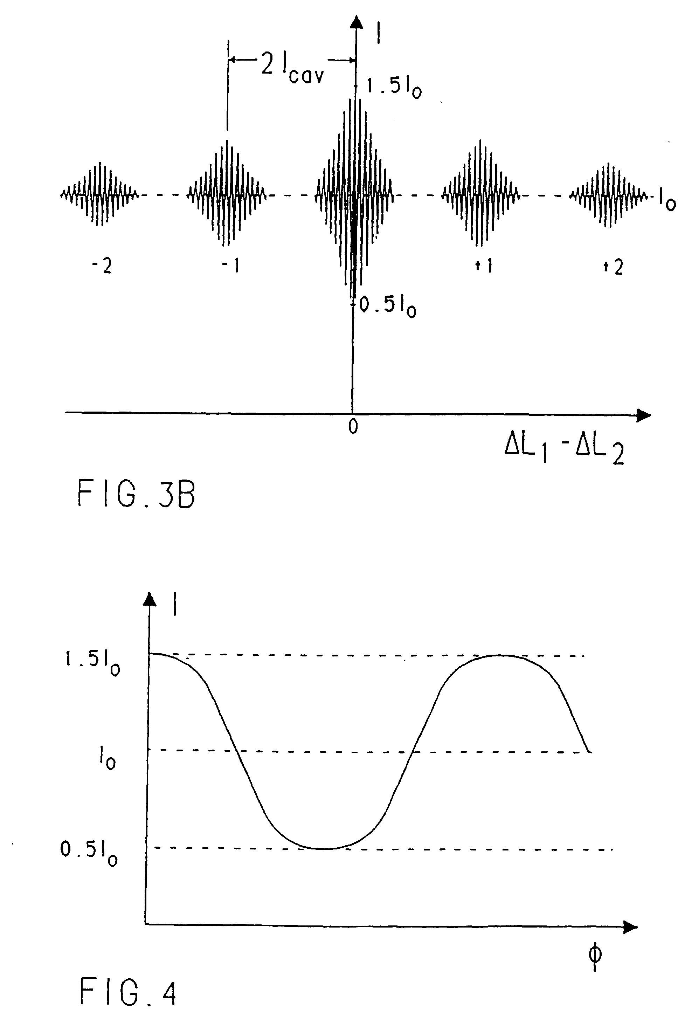

Das Tandem-Zweimodenfaser-Interferometer verhält sich damit wie ein einzelnes Interferometer mit dem Gangunterschied Delta L = Delta $L_1$-Delta $L_2$, mit dem Unterschied, dass der Interferenzkontrast um einen Faktor 2 reduziert ist. Die Intensität I nach Gleichung (16) ist in den Figuren 3A und 3B schematisch dargestellt. Fig. 3A zeigt den unmittelbaren Bereich um Delta $L_1$-Delta $L_2$ = 0 (Ordnung p=0; IDelta $L_1$-Delta $L_2$I $\leq$ einige 100µm). Fig. 3B stellt einen grösseren Ausschnitt aus dem Wertebereich von Delta $L_1$-Delta $L_2$ dar mit "Interferenzpaketen" höherer Ordnung (Ipl$\geq$0).

Zum Vergleich seien nachfolgend einige Zahlenwerte für das Tandem-Zweimodenfaser-Interferometer dem Michelson-Interferometer gegenübergestellt:

Michelson-Interferometer (in Luft):

Die Halbwertsbreite der Spitzen in der Funktion V(Delta L) liegt in Luft für viele kommerzielle Mehr-Moden-Laserdioden in der Grössenordnung 200 µm. Die optische Länge $I_{cav}$ des Laserrersonators beträgt ca. 1 mm. Der Abstand zweier Maxima ist damit etwa 2 mm. Die Höhe K der Maxima fällt gewöhnlich innerhalb der ersten 10 Ordnungen (Ipl$\leq$10) auf Werte von wenigen Prozent ab.

Tandem-Zweimodenfaser-Interferometer:

Der Unterschied Delta $n_{eff}$ = n($LP_{01}$)-n($LP_{11}$) der effektiven Brechungsindizes ist stark vom Fasertyp abhängig. Für eine Zwei-Moden-Faser für eine Wellenlänge lambda von 780 nm kann er grob in dem Bereich zwischen 0,001 und 0,015 liegen.

Für eine Faser mit z.B. Delta $n_{eff}$ = 0,01 ergeben sich folgende Parameter: Die Halbwertsbreite der Spitzen der Funktion V(1) entspricht einem Faserlängenunterschied in der Grössenordnung von (200 µm)/Delta $n_{eff}$ = 2 cm. Damit der totale Gangunterschied Delta $L_1$-Delta $L_2$ des Tandem-Interferometers noch sicher innerhalb des "Interferenzpakets" 0-ter Ordnung (p=0) liegt, sollten demnach die Längen der beiden Zwei-Moden-Fasern 4a und 4b auf einige Millimeter genau miteinander übereinstimmen. In der Praxis können solche Toleranzen problemlos eingehalten werden.

Der Faserlängenunterschied zwischen zwei Maxima von V(1) ist (2 mm)/Delta $n_{eff}$ = 20 cm. Das Maximum 10-ter Ordnung tritt demnach bei einer Faserlänge von 2 m auf. Infolge des relativ grossen Abstands zweier Maxima von V(1) können die Faserlängen leicht so eingestellt werden, dass die Bedingungen gemäss Gleichung (14) und (15) erfüllt sind.

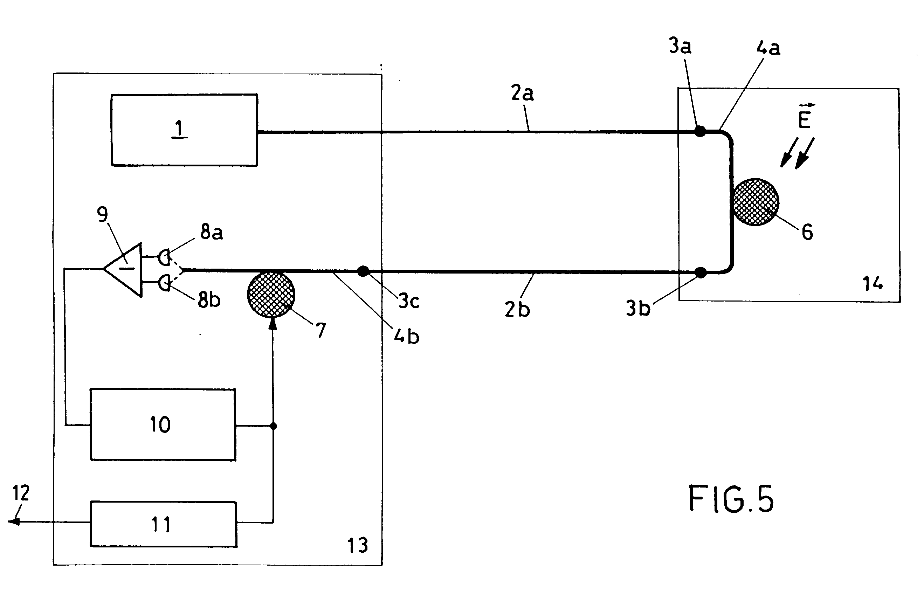

Eine bevorzugte Ausführungsform für den Aufbau eines Sensors für die elektrische Feld- und Spannungsmessung nach der Erfindung ist in Fig. 5 dargestellt. In einem elektrischen Wechselfeld E moduliert ein piezoelektrisches Sensorelement 6 (z.B. ein Quarz) die Länge der ersten Zwei-Moden-Faser 4a und damit auch den Phasenunterschied zwischen den beiden angeregten Moden. Der Phasenunterschied zwischen den am Ausgangsende der zweiten Zwei-Moden-Faser 4b interferierenden Wellen ist gegeben durch

$$(17) \qquad \Phi(t) = A*sin(omega*t) + \Phi^0_1(t) - \Phi^0_2(t)\ .$$

$\Phi^0_1(t)$ und $\Phi^0_2(t)$ sind die Phasendifferenzen zwischen den Moden der beiden Zwei-Moden-Fasern 4a und 4b, wenn keine Modulation erfolgt. $\Phi^0_1(t)$ und $\Phi^0_2(t)$ können sich z.B. infolge von Temperaturschwankungen (temperaturabhängige Faserlängen) zeitlich ändern. Die Temperaturfluktuationen der Gangunterschiede sind jedoch sehr viel kleiner als die Breite der Spitzen der Funktion V(Delta L), so dass der Interferenzkontrast dadurch praktisch nicht verändert wird. Gleichung (16) lautet dann

$$(18) \qquad I=I_0\{1+(1/2)V\cos(A^*\sin(omega^*t)+\Phi^0_1(t)-\Phi^0_2(t))\}$$

Die Intensität I ist in Fig. 4 für V=1 als Funktion der Phase $\Phi$ dargestellt. Zur Signaldetektion kann dann das bereits früher beschriebene Homodyn-Detektionsverfahren mit aktiver Phasenkompensation eingesetzt werden (siehe die eingangs zitierte EP-A1-O 433 824). Die Differenz $\Phi^0_1(t)-\Phi^0_2(t)$ wird auf pi/2 modulo 2*pi geregelt, der Term A*sin (omega*t) wird durch eine zusätzliche, gegenphasige Modulation kompensiert. Dazu ist ein piezoelektrischer Modulator 7 vorgesehen, der von einem Quadraturregler 10 gesteuert wird. Der Quadraturregler 10 erhält sein Eingangssignal von zwei am Ausgangsende der zweiten Zwei-Moden-Faser 4b angeordneten Detektoren 8a und 8b, die das optische Interferenzsignal in elektrische Signale umwandeln, aus denen mittels eines nachgeschalteten Subtrahierers 9 die Differenz gebildet wird. Aus dem Steuersignal des Quadraturreglers 10 wird mittels eines Hochpasses 11 das Messsignal extrahiert und an einem Signalausgang 12 zur Verfügung gestellt.

Im Unterschied zu den bekannten Verfahren moduliert der Modulator nicht die Sensorfaser selbst, sondern die zweite Zwei-Moden-Faser 4b. Die erste Zwei-Moden-Faser 4a (die eigentliche Sensorfaser) kann dann auf den unmittelbaren Bereich des Sensorelements 6 beschränkt bleiben und muss nicht die Distanz zwischen Sensorelement und Auswerteeinheit 13 überbrücken. Die erste Zwei-Moden-Faser bildet mit dem Sensorelement 6 zusammen einen kompakten und einfach aufgebauten Sensorkopf 14, der nur durch unempfindliche Monomoden-Fasern 2a, 2b mit der Auswerteeinheit 13 verbunden ist, in der sich die zweite Zwei-Moden-Faser 4b und der Modulator 7 samt Ansteuerung befinden. Die Terme A*sin(omega*t) und $\phi^0_1(t)-\phi^0_2(t)$ können im übrigen auch - wie bereits früher beschrieben - mit zwei separaten Modulatoren anstelle des Modulators 7 aus Fig. 5 kompensiert werden.

Die beiden (polarisationserhaltenden) Zwei-Moden-Fasern haben vorzugsweise einen Kern mit elliptischem Querschnitt. Die Faserparameter können dann so gewählt werden, dass für die Wellenlänge der Laserdiode nur der $LP_{01}$- und der gerade $LP_{11}$-Modus ausbreitungsfähig sind (siehe den eingangs zitierten Artikel von B. Y. Kim et al.). In Fasern mit rundem Kern wäre gleichzeitig mit dem geraden auch der ungerade $LP_{11}$-Modus ausbreitungsfähig.

Die beiden Monomode-Fasern 2a und 2b sind vorzugsweise polarisationserhaltend ausgebildet. Es können jedoch auch gewöhnliche Monomode-Fasern verwendet werden. Die Polarisation müsste dann aktiv kontrolliert werden, wie dies in T. Pikaar et al., J. Lightw. Tech. 7, 1982-1987 (1989) beschrieben ist. Dort wird insbesondere gezeigt, dass in einer Monomodefaser die Lichtpolarisation durch zwei lineare Doppelbrechungs-Modulatoren mit um 45° verdrehten Achsen kontrolliert werden kann.

Insgesamt ergibt sich mit der Erfindung ein robuster, genauer und einfach aufgebauter Sensor.

**Patentansprüche**

1. Faseroptischer Sensor für elektrische Wechselfelder und - spannungen, umfassend

   a) eine Lichtquelle (1);
   b) ein piezoelektrisches Sensorelement (6);
   c) eine erste Zwei-Moden-Faser (4a) mit einem Eingangsende und einem Ausgangsende, in der sich der $LP_{01}$-Grundmodus und der gerade $LP_{11}$-Modus ausbreiten können, und welche zumindest teilweise an dem Sensorelement (6) so fixiert ist, dass eine Dimensionsänderung des Sensorelements (6) in einem elektrischen Feld zu einer Längenänderung in der Faser führt;
   d) Mittel zum Messen der feldbedingten Längenänderung der Faser;
   e) eine erste sowie eine zweite Monomode-Faser (2a bzw. 2b) zur Uebertragung des Lichts zwischen der Lichtquelle (1) und dem Eingangsende der ersten Zwei-Moden-Faser (4a) sowie dem Ausgangsende der ersten Zwei-Moden-Faser (4a) und dem Eingang der Messmittel (4b), wobei
   f) die erste Monomode-Faser (2a) polarisationserhaltend ausgebildet ist oder Mittel zur aktiven Kontrolle der Polarisation vorhanden sind,

   dadurch gekennzeichnet, dass

   g) die Lichtquelle (1) eine Mehr-Moden-Laserdiode ist;
   h) die Messmittel eine zweite, zur ersten gleichartige Zwei-Moden-Faser (4b) umfassen;
   i) die Parameter der beiden Zwei-Moden-Fasern (4a,4b) so gewählt sind, dass der Interferenzkontrast (V) für die Gangunterschiede (Delta $L_1$, Delta $L_2$) beider Moden in den einzelnen Zwei-Moden-Fasern (4a,4b) und für die Summe der Gangunterschiede Delta $L_1$ + Delta $L_2$ jeweils ungefähr gleich Null ist; und

j) die zweite Monomode-Faser (2b) polarisationserhaltend ausgebildet ist oder Mittel zur aktiven Kontrolle der Polarisation vorhanden sind.

2. Faseroptischer Sensor nach Anspruch 1, dadurch gekennzeichnet, dass die Zwei-Moden-Fasern (4a, 4b) einen Kern mit elliptischem Querschnitt aufweisen.

3. Faseroptischer Sensor nach Anspruch 2, dadurch gekennzeichnet, dass die beiden Monomode-Fasern (2a, 2b) mit den beiden Zwei-Moden-Fasern (4a, 4b) so verbunden sind, dass in den beiden Zwei-Moden-Fasern (4a, 4b) die beiden ausbreitungsfähigen Moden durch das Licht aus der Lichtquelle (1) jeweils mit ungefähr gleicher Intensität angeregt werden.

4. Faseroptischer Sensor nach Anspruch 3, dadurch gekennzeichnet, dass die effektiven Brechungsindex-Unterschiede $n(LP_{01})$ - $n(LP_{11})$ für die beiden Moden in den beiden Zwei-Moden-Fasern (4a, 4b) und die Längen der beiden Zwei-Moden-Fasern (4a, 4b) jeweils gleich sind.

5. Faseroptischer Sensor nach Anspruch 4, dadurch gekennzeichnet, dass

a) die zweite Zwei-Moden-Faser (4b) zumindest teilweise an einem piezoelektrischen Modulator (7) fixiert ist;
b) am Ausgangsende der zweiten Zwei-Moden-Faser (4b) zwei Detektoren (8a, 8b) zur Messung der Intensitäten der beiden Moden angeordnet sind;
c) die Ausgangssignale der beiden Detektoren (8a, 8b) über einen Subtrahierer (9) auf den Eingang eines Quadraturreglers (10) gelangen;
d) der Ausgang des Quadraturreglers (10) den Modulator (7) steuert; und
e) das Ausgangssignal des Quadraturreglers (10) über einen Hochpass (11) auf einen Signalausgang (12) gegeben wird.

6. Faseroptischer Sensor nach Anspruch 5, dadurch gekennzeichnet, dass

a) die Lichtquelle (1), die zweite Zwei-Moden-Faser (4b) mit dem Modulator (7) und den Detektoren (8a, 8b), der Subtrahierer (9), der Quadraturregler (10) und der Hochpass (11) zu einer Auswerteeinheit (13) zusammengefasst sind;
b) die erste Zwei-Moden-Faser (4a) mit dem Sensorelement (6) in einem separaten Sensorkopf (14) angeordnet sind; und
c) Sensorkopf (14) und Auswerteeinheit (13) nur durch die zwei Monomode-Fasern (2a, 2b) miteinander in Verbindung stehen.

**Claims**

1. Fibre-optic sensor for alternating electric fields and voltages, comprising

(a) a light source (1);
(b) a piezoelectric sensor element (6);
(c) a first bimode fibre (4a) with an entrance end and an exit end, in which fibre the $LP_{01}$ fundamental mode and the even $LP_{11}$ mode can propagate, and which fibre is at least partially fixed to the sensor element (6) so that a change in the dimension of the sensor element (6) in an electric field leads to a change in length in the fibre;
(d) means for measuring the field-dependent change in length of the fibre;
(e) a first and a second monomode fibre (2a and 2b, respectively) for transmitting the light between the light source (1) and the entrance end of the first bimode fibre (4a) as well as the exit end of the first bimode fibre (4a) and the input of the measuring means (4b),
(f) the first monomode fibre (2a) being of polarization-maintaining design, or means being present for active control of the polarization,

characterized in that

(g) the light source (1) is a multimode laser diode;
(h) the measuring means comprise a second bimode fibre (4b) of the same type as the first;

(i) the parameters of the two bimode fibres (4a, 4b) are selected so that the interference contrast (V) is approximately equal to zero in each instance for the path differences delta ($L_1$, delta $L_2$) of the two modes in the individual bimode fibres (4a, 4b) and for the sum of the path differences delta $L_1$ + delta $L_2$; and

(j) the second monomode fibre (2b) being of polarization-maintaining design, or means being present for active control of the polarization.

2. Fibre-optic sensor according to Claim 1, characterized in that the bimode fibres (4a, 4b) exhibit a core of elliptical cross section.

3. Fibre-optic sensor according to Claim 2, characterized in that the two monomode fibres (2a, 2b) are connected to the two bimode fibres (4a, 4b) in such a manner that in the two bimode fibres (4a, 4b) the two modes which are viable for propagation are excited by the light from the light source (1) with approximately equal intensity in each instance.

4. Fibre-optic sensor according to Claim 3, characterized in that the effective refractive index differences $n(LP_{01})$ - n $(LP_{11})$ for the two modes in the two bimode fibres (4a, 4b) and the lengths of the two bimode fibres (4a, 4b) are respectively equal.

5. Fibre-optic sensor according to Claim 4, characterized in that

(a) the second bimode fibre (4b) is at least partially fixed to a piezoelectric modulator (7);

(b) two detectors (8a, 8b) for the measurement of the intensities of the two modes are disposed at the exit end of the second bimode fibre (4b);

(c) the output signals of the two detectors (8a, 8b) pass via a subtractor (9) to the input of a quadrature regulator (10);

(d) the output of the quadrature regulator (10) controls the modulator (7); and

(e) the output signal of the quadrature regulator (10) is passed via a high-pass filter (11) to a signal output (12) .

6. Fibre-optic sensor according to Claim 5, characterized in that

(a) the light source (1), the second bimode fibre (4b) with the modulator (7) and the detectors (8a, 8b), the subtractor (9), the quadrature regulator (10) and the high-pass filter (11) are combined into an evaluation unit (13);

(b) the first bimode fibre (4a) together with the sensor element (6) are disposed in a separate sensor head (14); and

(c) sensor head (14) and evaluation unit (13) are connected to one another only by the two monomode fibres (2a, 2b).

**Revendications**

1. Capteur à fibre optique pour les champs et les tensions alternatifs électriques comprenant :

a) une source de lumière (1) ;

b) un élément capteur piézo-électrique (6) ;

c) une première fibre à deux modes (4a) avec une extrémité d'entrée et une extrémité de sortie, dans laquelle le mode fondamental $LP_{01}$ et le mode direct $LP_{11}$ peuvent se propager, et qui est au moins partiellement fixée à l'élément capteur (6) de telle sorte qu'une modification de la dimension de l'élément capteur (6) dans un champ électrique mène à une modification de la longueur dans la fibre ;

d) un moyen pour mesurer la variation de longueur de la fibre, déterminée par le champ ;

e) une première ainsi qu'une seconde fibre monomode (2a respectivement 2b) pour la transmission de la lumière entre la source de lumière (1) et l'extrémité d'entrée de la première fibre à deux modes (4a) ainsi que vers l'extrémité de sortie de la première fibre à deux modes (4a) et vers l'entrée du moyen de mesure (4b),

f) la première fibre monomode (2b) étant faite de manière à conserver la polarisation ou bien il existe des moyens pour le contrôle actif de la polarisation.

caractérisé en ce que

g) la source de lumière (1) est une diode laser multimode ;

h) les moyens de mesure comportent une seconde fibre à deux modes (4b) identique à la première ;

i) les paramètres des deux fibres à deux modes (4a, 4b) sont choisis de telle sorte que le contraste de l'interférence (V) pour les différences de trajet (Delta $L_1$, Delta $L_2$) des deux modes dans les fibres individuelles à deux modes (4a, 4b) et pour la somme des différences de trajet Delta $L_1$ + Delta $L_2$ est chaque fois environ égale à zéro ; et

j) la seconde fibre monomode (2b) est faite de manière à conserver la polarisation ou bien il existe des moyens pour le contrôle actif de la polarisation.

2. Capteur à fibre optique selon la revendication 1, caractérisé en ce que les fibres à deux modes (4a, 4b) présentent un coeur de section transversale elliptique.

3. Capteur à fibre optique selon la revendication 2, caractérisé en ce que les deux fibres monomodes (2a, 2b) sont reliées aux deux fibres à deux modes (4a, 4b) de telle sorte que dans les deux fibres à deux modes (4a, 4b), les deux modes pouvant se propager sont excités par la lumière de la source de lumière (1) respectivement avec même intensité environ.

4. Capteur à fibre optique selon la revendication 3, caractérisé en ce que les différences d'indices de réfraction effectives n($LP_{01}$) - n($LP_{11}$) pour les deux modes dans les deux fibres à deux modes (4a, 4b) et les longueurs des deux fibres à deux modes (4a, 4b) sont respectivement égales.

5. Capteur à fibre optique selon la revendication 4, caractérisé en ce que

a) la seconde fibre à deux modes (4b) est fixée au moins partiellement à un modulateur piézo-électrique (7) ;

b) deux détecteurs (8a, 8b) pour la mesure des intensités des deux modes sont disposés à l'extrémité de sortie de la seconde fibre à deux modes (4b) ;

c) les signaux de sortie des deux détecteurs (8a, 8b) aboutissent, à travers un soustracteur (9), à l'entrée d'un régulateur de la quadrature (10) ;

d) la sortie du régulateur de la quadrature (10) commande le modulateur (7) ; et

e) le signal de sortie du régulateur de la quadrature (10) est acheminé à travers un filtre passe-haut (11) vers une sortie de signal (12).

6. Capteur à fibre optique selon la revendication 5, caractérisé en ce que

a) la source de lumière (1), la seconde fibre à deux modes (4b) avec le modulateur (7) et les détecteurs (8a, 8b), le soustracteur (9), le régulateur de la quadrature (10) et le filtre passe-haut (11) sont regroupés dans une unité de traitement (13) ;

b) la première fibre à deux modes (4a) est disposée avec l'élément capteur (6) dans une tête de capteur séparée (14) ; et

c) la tête de capteur (14) et l'unité de traitement (13) ne sont en liaison l'une avec l'autre qu'à travers les deux fibres monomodes (2a, 2b).

EP 0 529 339 B1

1  2a  3a  4a  3b  2b  3c  4b  5

$\Delta L$

$2\Delta L$

$LP_{11}$

$LP_{11}$

$LP_{01}$

$LP_{01}$

$LP_{01}$

$LP_{01}$

$\Delta L$

$\Delta L$

$\Delta L$

$\Delta L$

FIG.1

FIG.2

FIG.3A

FIG.3B

FIG.4

FIG.5